# EUROPÄISCHE PATENTANMELDUNG

(11) **EP 3 872 855 A1**
(43) Veröffentlichungstag der Anmeldung: **01.09.2021**
(21) Anmeldenummer: 20159810.9
(22) Anmeldetag: 27.02.2020
(51) Int. Cl.: H01L 23/498, H01L 23/488, H01L 21/60, H01L 23/367, H01L 23/373

(54) **SUBSTRATHALBZEUG FÜR EINE LEISTUNGSELEKTRONISCHE BAUGRUPPE MIT EINER LEITSTRUKTUR MIT AUSFORMUNGEN UND ENTSPRECHENDES HERSTELLUNGSVERFAHREN**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Strogies, Jörg, 14163 Berlin (DE)

(57) **Zusammenfassung**

Die Erfindung betrifft ein Substrathalbzeug (100) für eine leistungselektronische Baugruppe (1), eine leistungselektronische Baugruppe (1) sowie ein Verfahren zum Herstellen eines Substrathalbzeugs (100). Um ein verbessertes Substrathalbzeug (100) anzugeben wird vorgeschlagen, dass das Substrathalbzeug (100) ein Substrat (10) und eine Leitstruktur (20) mit einer oder mehreren Kontaktflächen (26) zur Kontaktierung eines Leistungshalbleiters (200) aufweist. Die Leitstruktur (20) weist eine Leitebene (22) und Ausformungen (24) auf, wobei die Ausformungen (24) die Kontaktflächen (26) aufweisen und zumindest einen Teil einer zwischen der Leitebene (22) und dem Leistungshalbleiter (200) notwendigen Isolationsstrecke (150) (d.h., der Strecke zwischen den Kontakten (210) des Leistungshalbleiters (200) und der Leitebene (22) nach Fügen des Leistungshalbleiters (200) auf das Substrathalbzeug (100)) bilden. Die Leitstruktur (20) kann in Dickschichttechnik aufgebracht sein. Auf den Ausformungen (24) kann zumindest abschnittsweise ein Fügematerial (50), insbesondere eine Sinterpaste, aufgebracht sein. Ein Isolationsmaterial (30) kann so auf die Leitstruktur (20) aufgebracht sein, dass die Kontaktflächen (26) und das Isolationsmaterial (30) oder die Ausformungen (24) und das Isolationsmaterial (30) eine im Wesentlichen planare Fläche bilden. Ein Dielektrikum (35) kann so auf dem Isolationsmaterial (30) angeordnet sein, dass eine Spaltschließung eintritt, wenn der Leistungshalbleiter (200) auf das Substrathalbzeug (100) gefügt ist. Die Höhe (H24) der Ausformungen (24) kann so gewählt sein, dass ein auf die Leitstruktur (20) und/oder die Leitebene (22) aufgebrachtes Isolationsmaterial (30) so dimensioniert ist, dass die Isolationsstrecke (150) durch das Isolationsmaterial (30) bereitgestellt wird, womit es auf ein weiteres Dielektrikum verzichtet werden kann. Der Leistungshalbleiter (200) kann mehrere Kontakte (210) aufweisen, die an jeweils eine der Kontaktflächen (26) der Ausformungen (24) gefügt sind.

## Beschreibung

Die Erfindung betrifft ein Substrathalbzeug für eine leistungselektronische Baugruppe, eine leistungselektronische Baugruppe sowie ein Verfahren zum Herstellen eines Substrathalbzeugs.

Ein derartiges Substrathalbzeug kommt beispielsweise in modernen Umrichtern für elektrische Antriebe, Generatoren oder auch Solarpanels zum Einsatz. Bei der Chipdirektmontage sind aus konstruktiven Gründen wie notwendiger thermomechanischer Leistungsfähigkeit und elektrischer Isolationsfähigkeit definierte Fügezonenhöhen z.B. von Sinterverbindungen notwendig. Die Applikation der notwendigen Schichtdicken stellt technologisch gesehen eine wesentliche Herausforderung dar, da unter anderem das Thixotropieverhalten des zumeist in Pastenform via Schablonendruck übertragenen Materials kritisch ist. Neben unerwünschten Effekten wie ein Verlaufen der applizierten Depots nach dem Druck leidet auch die Koplanarität, welche bei der Sintermontage infolge des Nichtaufschmelzens des Fügematerials besondere Bedeutung besitzt. Zur Steigerung der thermomechanischen Zuverlässigkeit und insbesondere bei Anwendungen mit höheren elektrischen Feldstärken und damit verbundenen Isolationsnotwendigkeiten und damit einhergehenden Isolationsstrecken sind geeignete Materialien zwischen den Chips und den Substratoberflächen notwendig. Beispielweise erfolgt der Eintrag von so genannten Capillary-Flow-Underfills, die diese Aufgaben in den Aufbauten übernehmen. Deren Applikation ist technologisch aufwendig und hinsichtlich der für leistungselektronische Anwendungen notwendigen Defektfreiheit teils schwierig mit ausreichendem Yield zu realisieren. Bisher sind hier eine aufwendige Prozessgestaltung und assoziierte intensive Inspektionen notwendig. Der Yield-Loss wird aktuell teilweise durch entsprechenden Verwurf von teilprozessierten Funktionseinheiten des darauf aufbauenden Gesamtsystems gemindert. Darunter leidet dementsprechend die Kosteneffizienz.

Der Erfindung liegt die Aufgabe zugrunde, die genannten Probleme hinsichtlich der Isolation zu lösen und ein verbessertes Substrathalbzeug anzugeben. Diese Aufgabe wird durch ein Substrathalbzeug für eine leistungselektronische Baugruppe mit den im Anspruch 1 angegebenen Merkmalen gelöst.

Dazu weist das Substrathalbzeug ein Substrat und eine Leitstruktur mit ein oder mehreren Kontaktflächen zur Kontaktierung eines Leistungshalbleiters auf. Erfindungsgemäß weist die Leitstruktur eine Leitebene mit Ausformungen auf, wobei die Ausformungen die Kontaktflächen zur Kontaktierung des Leistungshalbleiters ausbilden. Besonders vorteilhaft ist, dass zumindest ein Teil einer zwischen der Leitebene und dem Leistungshalbleiter notwendigen Isolationsstrecke durch die Ausformungen gebildet wird. In anderen Worten wird die durch die Ausformungen entstehende Topologische Erhebung dazu genutzt den Raum für eine Isolationsstrecke zu vergrößern um so wiederum Raum für ein Isolationsmaterial direkt am Chip zu schaffen.

Die Kontaktflächen bilden dabei einen Bestückplatz, auch Chip-Bestückplatz, für einen z.B. ungehäusten Leistungshalbleiter-Chip.

Die Erfindung löst also die Aufgabe durch ein Ausnutzen der konstruktiven Gestaltungsmöglichkeiten, welche eine Adaption der Dickschichttechnik für die Prozessierung der Verdrahtungsträger (vorwiegend keramikbasierende Substrate) bietet. Hierbei können Leit-, Widerstands-, Dielektrika- und Glasurpasten durch Druck- und Dispensprozesse in verschiedenen Dicken auch entsprechend lokal abgestuft appliziert werden. Der geplante Aufbau des Grundsubstrats unter Nutzung dieser konstruktiv-technologischen Möglichkeiten ermöglicht die kostengünstige Erweiterung auf die Generierung der technischen Merkmale, z. B. die Isolationsstrecke, des Substrathalbzeugs mit dem entsprechend modifizierten Chip-Bestückplatz, ohne dabei unvertretbare zusätzliche Kosten zu verursachen.

Die Leitstruktur mit ihren Ausformungen bildet dabei ein topographisch ausgeformtes Leitbahnsystem und übernimmt im Bereich der Chipverbindung, also am Bestückplatz, einen wesentlichen Anteil an der erforderlicher Fügezonenhöhe und damit einen wesentlichen Anteil an der notwendigen Isolationsstrecke. Die Fügezonenhöhe muss so nicht komplett aus Sintermaterial generiert werden. Dies ist technologisch vorteilhaft, da die Fügezonenhöhe bereits als Bestandteil des Substrats ausgebildet ist. Die Leitstruktur kann dabei für ihre elektrisch leitend miteinander in Verbindung stehenden Teile monolithisch also als ein Teil in Dickschichttechnik gefertigt sein.

Die Kontaktflächen sind dabei vorzugsweise zur Kontaktierung der Chip-Vorderseite ausgebildet. D.h. die Chipseite, die mehrere Kontakte aufweist und die Seite, die keine vollflächige, durchgehende Metallisierung aufweist. Zwischen dem Chip, also dem Leistungshalbleiter, und dem Substrat entsteht so in der Regel ein (Rest-)Spalt, der entsprechend isoliert werden muss. Die vorliegende Erfindung ermöglicht es vorteilhaft diesen Restspalt zu minimieren bzw. die Notwendigkeit einer Restspaltschließung zu verringern. Die Kontaktflächen können weiterhin vorzugsweise zur Kontaktierung eines Halbleiters mit mehreren voneinander elektrisch isolierten Kontakten (also z.B. Gate, Drain und/oder Source) ausgebildet sein, sodass sich Isolationsanforderungen ergeben.

Die Ausformungen dienen dabei weiterhin vorteilhaft als chipnahe Wärmekapazität, die das Kurzeitverhalten erheblich positiv beeinflusst. Weiterhin ist die CTE-Anpassung (Anpassung des coefficient of thermal expansion) zwischen Halbleiter, Leitstruktur und Substrat verbessert, da die Ausformungen einen entsprechend weicheren Übergang zwischen Halbleiter und Substrat ermöglichen.

In einer weiteren Ausführungsform bildet die Höhe der Ausformungen zumindest 60%, 70% oder 80% der Isolationsstrecke bilden. Die Isolationsstrecke ist dabei als der Abstand zwischen der dem Substrat zugewandten Chipseite bzw. den Kontakten des Chips und der Leitebene definiert. Vorteilhafterweise kann ein Großteil der Isolationsstrecke bereits durch die erfindungsgemäßen Ausformungen bzw. die Höhe der Ausformungen realisiert werden, so kann weniger Fügematerial verwendet werden und die Isolationsstrecke ist daher einfacher zur Verfügung zu stellen.

In einer weiteren Ausführungsform ist auf den Ausformungen zumindest abschnittsweise ein Fügematerial, insbesondere eine Sinterpaste, aufgebracht. Die vorliegende Erfindung ermöglicht es bereits mit Fügematerial vorkonfektionierte Substrathalbzeuge zur Verfügung zu stellen, sodass gesetzt werden muss und das sind der Vorgang ohne weitere Vorbereitung durchgeführt werden kann.

In einer weiteren Ausführungsform bildet die Höhe des Fügematerials höchstens 30%, 20% oder 10% der Isolationsstrecke aus. Vorzugsweise ist das Fügematerial maximal 30pm hoch. Im Bereich der Chipverbindung wird bereits durch die Ausformungen ein wesentlicher Anteil der erforderlichen Fügezonenhöhe zur Verfügung gestellt. Die Fügezonenhöhe ist der notwendige Abstand zwischen dem Leistungshalbleiter und der Leitebene, wobei auch thermomechanische Eigenschaften berücksichtigt werden müssen.

In einer weiteren Ausführungsform ist ein Isolationsmaterial so auf die Leitstruktur aufgebracht, dass die Bestückplatz und das Isolationsmaterial eine im Wesentlichen planare Fläche bilden. Das Isolationsmaterial ist dabei so auf die Leitstruktur aufgebracht, dass die Stellen auf dem Bestückplatz, die mit Fügematerial versehen werden sollen, frei vom Isolationsmaterial bleiben. Hier kann z. B. ein Glasur-Komplementärdruck zum Einsatz kommen, der durch Anpassung der Dicken vorteilhaft größeren Anteil an notwendiger Isolationsschicht unter den montierten Chips übernimmt. Diese Funktion ist dabei vorteilhaft bereits als Teil des Substrates realisiert. Dies führt gleichzeitig zu einer weitestgehenden Planarisierung des Chip-Bestückplatzes um die Kontaktflächen herum. Besonders vorteilhaft ist dabei die nur noch geringe Spaltbildung unter dem dann gefügten Chip. Als Beispiel kann das Substrathalbzeug als Dickschichtverdrahtungsträger realisiert werden. Alternativ und oder ergänzend können die Ausformungen und ein auf die Leitstruktur aufgebrachtes Isolationsmaterial eine im Wesentlichen planare Fläche bilden.

In einer weiteren Ausführungsform ist ein auf die Leitstruktur aufgebrachtes Isolationsmaterial als Glasur ausgebildet. Dies ist besonders vorteilhaft, da so sehr widerstandsfähige und dabei sehr gut isolierende Isolationsschichten aufgebracht werden. In Verbindung mit den Ausformungen der Leitstruktur, z.B. in Dickschichttechnik realisiert, ergeben sich so vorteilhaft Freiheitsgrade bzgl. der Gestaltung von Leistungsmodulen und deren Isolationsanforderungen.

In einer weiteren Ausführungsform ist die Leitstruktur in Dickschichttechnik aufgebracht. Die so ermöglichten Ausformungen können dabei weitere Funktionen erfüllen insbesondere können dabei notwendige Isolationsstrecken bereits durch die Höhe der Ausformungen zur Verfügung gestellt werden.

In einer weiteren Ausführungsform ist ein Dielektrikum so auf dem Isolationsmaterial angeordnet, dass eine Spaltschließung eintritt, wenn der Leistungshalbleiter auf das Substrathalbzeug gefügt ist. In anderen Worten verformt sich das Dielektrikum bei der Montage des Leistungshalbleiters so, dass ein vorhandener Restspalt zwischen der Isolationsschicht und dem Leistungshalbleiter mit dem Dielektrikum gefüllt ist. Als Dielektrikum kann insbesondere ein Polyimid zum Einsatz kommen.

In einer weiteren Ausführungsform ist die Höhe der Ausformungen so gewählt, dass ein auf die Leitstruktur und/oder die Leitebene aufgebrachtes Isolationsmaterial so dimensioniert ist, dass die Isolationsstrecke insbesondere vollständig durch das Isolationsmaterial bereitgestellt wird. In anderen Worten wird durch die Höhe der Ausformungen Raum für das Isolationsmaterial geschaffen und es kann auf ein weiteres Dielektrikum verzichtet werden. Weiterhin kann die vom Halbleiter oder dem Design, also z. B. die anliegenden Spannungen, abhängige Isolationsstrecke vollständig durch das Isolationsmaterial ausgebildet sein. Das Isolationsmaterial kann dabei vorteilhaft in der Höhe aufgebracht werden, in der es die Höhe der Ausformungen zulässt. Die Ausformungen ermöglichen so Isolationsmaterialstärken, wie sie sonst nicht oder nur schwierig umsetzbar sind.

Besonders vorteilhaft ist eine Ausführungsform in der die verbesserten Isolationseigenschaften durch die Restspaltschließung mittels des Dielektrikums und eine erhöhte Robustheit durch unterliegende als Glasschicht ausgebildete Isolationsschicht erreicht wird. Diese Kombination erreicht im Vergleich zu den einzelnen Maßnahmen deutlich verbesserte Isolations- und Robustheits-Eigenschaften.

Das Dielektrikum kann dabei ergänzend oder alternativ um die Kontaktflächen herum angeordnet sein. Dabei kann das Dielektrikum teilweise oder vollständig auf dem Isolationsmaterial angeordnet sein; ebenso kann das Dielektrikum teilweise oder vollständig auf der Leitebene angeordnet sein.

Die Aufgabe wird weiterhin durch eine Leistungselektronische Baugruppe gelöst, die zumindest ein Substrathalbzeug nach einer der vorhergehenden Ausführungsformen und zumindest einen mit einem Fügematerial darauf gefügten Leistungshalbleiter aufweist. Die Baugruppe ist dabei besonders robust und einfach auf die Anforderungen der Endanwendung flexibel anpassbar.

In einer weiteren Ausführungsform weist das Fügematerial im gefügten Zustand eine maximale Höhe von 30 µm, insbesondere 20 µm oder 10 µm auf. Derartig geringe Fügematerial-Stärken sind mit den Substrathalbzeugen nach den vorhergehenden Ausführungsformen flexibel und einfach realisierbar. Nach dem Fügen ist das Fügematerial komprimiert und kann dabei unter 10% der Isolationsstrecke ausbilden. Dies ist besonders effizient, da mit geringen Mengen Fügematerial gearbeitet werden kann.

In einer weiteren Ausführungsform weist der Leistungshalbleiter mehrere Kontakte auf, die an jeweils eine der Kontaktflächen der Ausformungen gefügt sind. In anderen Worten ist für jeden der Kontakte eine Ausformung mit einer Kontaktfläche vorgesehen. Diese sind vorzugsweise untereinander elektrisch isoliert, also nicht miteinander elektrisch verbunden.

Die Aufgabe wird weiterhin durch ein Verfahren zum Herstellen eines Substrathalbzeugs gelöst. Das Verfahren umfasst die Schritte:
- Bereitstellen eines Substrats,
- Aufbringen einer Leitebene auf das Substrat, wobei die Leitebene einen Teil einer Leitstruktur bildet,
- Aufbringen von Ausformungen der Leitstruktur, sodass sich ein oder mehrere Kontaktflächen ausbilden,
- Aufbringen eines Isolationsmaterials auf die Leitebene unter Aussparung der Kontaktflächen.

In weiteren Schritten kann ein Fügematerial bereits auf die Kontaktflächen aufgebracht werden.

Im Folgenden wird die Erfindung anhand der in den Figuren dargestellten Ausführungsbeispiele näher beschrieben und erläutert. Es zeigen:
- FIG 1: ein Ausführungsbeispiel eines Substrathalbzeugs,
- FIG 2: ein Substrathalbzeug und einen Leistungshalbleiter,
- FIG 3: ein Leistungselektronische Baugruppe,
- FIG 4: eine Ausführungsform mit Restspaltschließung und
- FIG 5: die Ausführungsform aus FIG 4 mit montiertem Halbleiter.

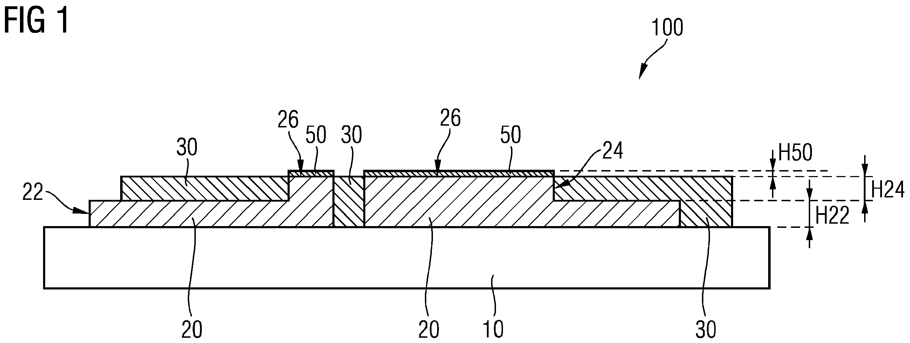

FIG 1 zeigt ein Ausführungsbeispiel eines Substrathalbzeugs 100, dass ein Substrat 10, eine Leitstruktur 20 sowie ein Isolationsmaterial 30 aufweist. Die Leitstruktur 20 weist dabei einer Leitebene 22 und Ausformungen 24 auf. Die Ausformungen 24 dienen zur Kontaktierung eines hier nicht gezeigten Leistungshalbleiters. Zur Kontaktierung des Leistungshalbleiters weisen die Ausformungen 24 Kontaktflächen 26 auf. Auf diesen Kontaktflächen 26 ist im vorliegenden Fall ein Fügematerial 50 aufgebracht. Das Fügematerial 50 kann dabei eine Sinterpaste sein. Das Isolationsmaterial 30 kann dabei eine Glasur in Dickschichttechnik sein. Das Isolationsmaterial 30 ist dabei so auf der Leitebene 22 aufgebracht, dass die Kontaktflächen 26 der Ausformungen frei vom Isolationsmaterial 30 sind.

Die Leitebene 22 weist dabei eine Höhe H22 auf. Die Ausformungen 24 weisen eine Höhe H24 auf, die ein Maß dafür ist, wie weit die Ausformungen 24 aus der Leitebene 22 heraussteht und damit den Abstand des Leistungshalbleiters von der Leitebene 22 maßgeblich definiert. Fügematerial 50 weist eine Höhe H50 auf, die über die Höhe H24 der Ausformungen 24 hinausgeht.

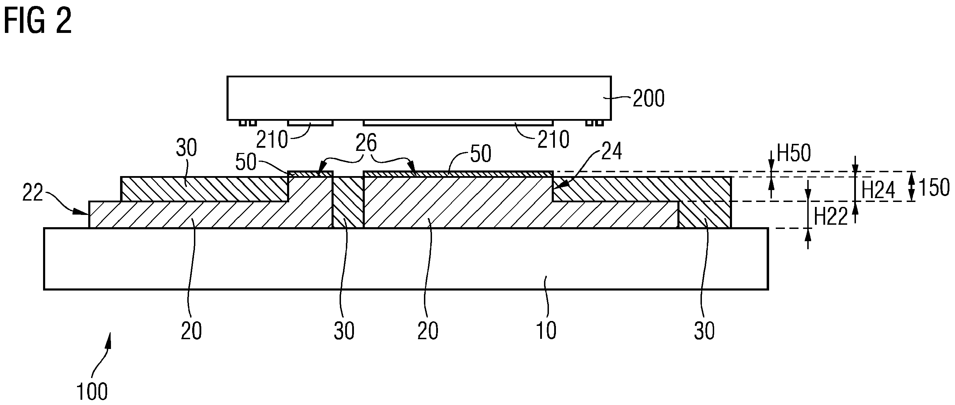

FIG 2 zeigt das aus FIG 1 bekannte Substrathalbzeug 100, wobei über den Kontaktflächen 26 mit dem darauf aufgebrachten Fügematerial 50, z. B. eine Sinterpaste, ein Leistungshalbleiter 200 angeordnet ist. Der Leistungshalbleiter 200 weist in diesem Fall Kontakte 210 auf, wobei die Kontaktflächen 26 passend zu den Kontakte 210 angeordnet sind. Design des Substrathalbzeugs 100 ist also bereits auf den Leistungshalbleiter 200 angepasst. Die Strecke zwischen den Kontakten 210 und der Leitebene 22 ist als notwendige Isolationsstrecke 150 eingezeichnet. Diese setzt sich im vorliegenden Fall zumindest aus der Höhe H50 der Fügematerials 50 und der Höhe H24 der Ausformungen 24 zusammen.

Bei der Herstellung eines Dickschichtverdrahtungsträger unter Verwendung von Glasur-Komplementärdruck als Isolationsmaterial 30 übernimmt das Isolationsmaterial 30 durch Anpassung der Höhen vorteilhaft einen größeren Anteil an der notwendigen Isolationsschicht unter den montierten Leistungshalbleitern 200. Als Teil des Substrathalbzeugs 100 wird so gleichzeitig eine weitgehende Planarisierung des Chip-Bestückplatzes inkl. der Kontaktflächen 26 erreicht, was vorteilhaft eine nur noch geringe Spaltbildung unter dem gefügten Chip (Leistungshalbleiter 200) zur Folge hat.

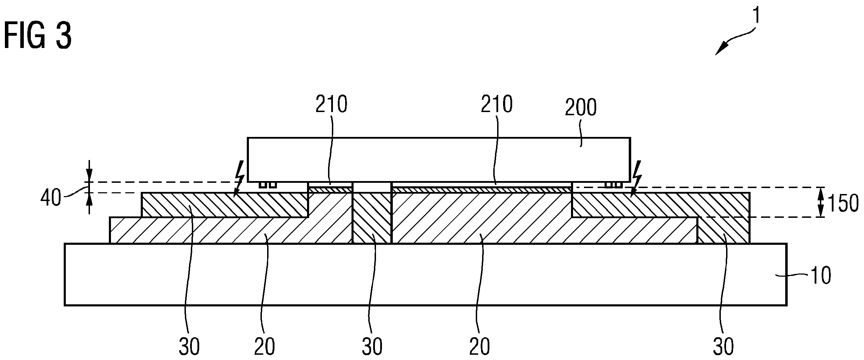

FIG 3 zeigt nun eine Ansicht in der der Leistungshalbleiter 200 bereits auf das aus FIG 1 und 2 bekannte Halbleitersubstrat 100 gefügt ist und somit eine leistungselektronische Baugruppe 1 entsteht. Zu sehen ist, dass die Ausformungen 24 und das daran angrenzende Isolationsmaterial 30 bereits einen großen Anteil der Isolationsstrecke 150 bilden. Ein Spalt 40 entsteht zwischen dem Substrathalbzeug 100 und dem Leistungshalbleiter 200. der Spalt 40 muss dabei nicht zwangsläufig gefüllt werden, wenn die Isolation durch die Isolationsschicht aus dem Isolationsmaterial 30 bereits ausreichend ist.

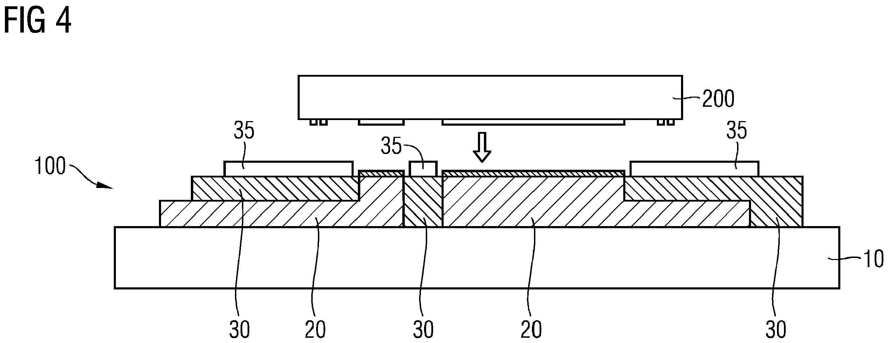

FIG 4 zeigt eine weitere Ausführungsform eines Substrathalbzeug 100, aus den Figuren 1-3 bekannt ist, wobei auf dem Isolationsmaterial 30 weiterhin ein Dielektrikum 35 aufgebracht ist, dass zur Restspaltschließung nach dem Fügen des Leistungshalbleiters 200 dient. Dabei ist zu beachten, dass die Sinterpaste, also das Fügematerial 50 hier nicht höher aufgebracht ist, als dass Dielektrikum 35. Dies hat zur Folge, dass das Dielektrikum 35 sich beim Fügen des Leistungshalbleiters 200 verformt und somit eine ideale Restspaltschließung zur Folge hat.

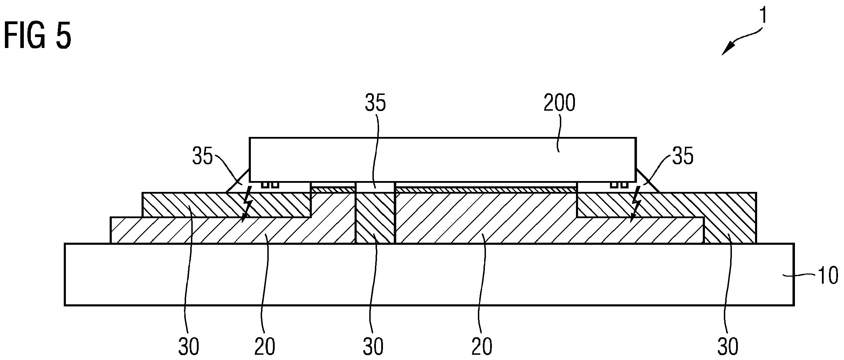

FIG 5 zeigt nun eine leistungselektronische Baugruppe 1, die aus dem Substrathalbzeug 100 mit dem daran gefügten Leistungshalbleiter 200 gefertigt wurde. Das Dielektrikum 35 ist in die Spalte zwischen dem Leistungshalbleiter 200 und dem Isolationsmaterial 30 eingedrungen und ermöglicht so eine deutlich verbesserte Spaltschließung und Isolation der leistungselektronischen Baugruppe 1. So können auf geringem Bauraum hohe Leistungsdichten realisiert werden und die thermomechanische Stabilität kann weiter verbessert werden.

Zusammenfassend betrifft die Erfindung ein Substrathalbzeug für eine leistungselektronische Baugruppe, eine leistungselektronische Baugruppe sowie ein Verfahren zum Herstellen eines Substrathalbzeugs. Um ein verbessertes Substrathalbzeug anzugeben wird vorgeschlagen, dass das Substrathalbzeug 100 ein Substrat 10 und eine Leitstruktur 20 mit ein oder mehreren Kontaktflächen 26 zur Kontaktierung eines Leistungshalbleiters 200 aufweist. Die Leitstruktur 20 weist eine Leitebene 22 und Ausformungen 24 auf, wobei die Ausformungen 24 die Kontaktflächen 26 aufweisen und zumindest einen Teil einer zwischen der Leitebene 22 und dem Leistungshalbleiter 200 notwendigen Isolationsstrecke 150 bilden.

### Bezugszeichen:

- 1: Leistungselektronische Baugruppe
- 100: Substrathalbzeug
- 10: Substrat
- 20: Leitstruktur
- 22: Leitebene der Leitstruktur
- 24: Ausformung der Leitstruktur
- 26: Kontaktfläche der Ausformung
- 30: Isolationsmaterial
- 35: Dielektrikum
- 40: Spalt
- 50: Fügematerial

- H22: Höhe der Leitebene
- H24: Höhe der Ausformungen
- H50: Höhe des Fügematerials

- 150: Isolationsstrecke

- 200: Leistungshalbleiter
- 210: Kontakte des Leistungshalbleiters

## Patentansprüche

1. Substrathalbzeug (100) für eine leistungselektronische Baugruppe (1) aufweisend ein Substrat (10) und eine Leitstruktur (20) mit ein oder mehreren Kontaktflächen (26) zur Kontaktierung eines Leistungshalbleiters (200),
wobei die Leitstruktur (20) eine Leitebene (22) und Ausformungen (24) aufweist,
wobei die Ausformungen (24) die Kontaktflächen (26) und zumindest einen Teil einer Isolationsstrecke (150) zwischen der Leitebene (22) und dem Leistungshalbleiter (200) ausbilden.

2. Substrathalbzeug (100) nach Anspruch 1, wobei die Höhe (H24) der Ausformungen (24) zumindest 60%, 70% oder 80% der Isolationsstrecke (150) bildet.

3. Substrathalbzeug (100) nach Anspruch 1 oder 2, wobei auf den Ausformungen (24) zumindest abschnittsweise ein Fügematerial (50), insbesondere eine Sinterpaste, aufgebracht ist.

4. Substrathalbzeug (100) nach Anspruch 3, wobei die Höhe (H50) des Fügematerials (50) höchstens 30%, 20% oder 10% der Isolationsstrecke (150) ausbildet, vorzugsweise maximal 30pm.

5. Substrathalbzeug (100) nach einem der vorangehenden Ansprüche, wobei ein Isolationsmaterial (30) so auf die Leitstruktur (20) aufgebracht ist, dass die Kontaktflächen (26) und das Isolationsmaterial (30) eine im Wesentlichen planare Fläche bilden.

6. Substrathalbzeug (100) nach einem der vorangehenden Ansprüche, wobei die Ausformungen (24) und ein auf die Leitstruktur (20) aufgebrachtes Isolationsmaterial (30) eine im Wesentlichen planare Fläche bilden.

7. Substrathalbzeug (100) nach einem der vorangehenden Ansprüche, wobei auf die Leitstruktur (20) ein Isolationsmaterial (30) aufgebracht ist, das vorzugsweise als Glasur ausgebildet ist.

8. Substrathalbzeug (100) nach einem der vorangehenden Ansprüche, wobei die Leitstruktur (20) in Dickschichttechnik aufgebracht ist.

9. Substrathalbzeug (100) nach einem der Ansprüche 5 - 8, wobei ein Dielektrikum (35) so auf dem Isolationsmaterial (30) angeordnet ist, dass eine Spaltschließung eintritt, wenn der Leistungshalbleiter (200) auf das Substrathalbzeug (100) gefügt ist.

10. Substrathalbzeug (100) nach einem der vorhergehenden Ansprüche, wobei die Höhe (H24) der Ausformungen (24) so gewählt ist, dass ein auf die Leitstruktur (20) und/oder die Leitebene (22) aufgebrachtes Isolationsmaterial (30) so dimensioniert ist, dass die Isolationsstrecke (150) durch das Isolationsmaterial (30) bereitgestellt wird.

11. Leistungselektronische Baugruppe (1), aufweisend zumindest ein Substrathalbzeug (100) nach einem der vorhergehenden Ansprüche und zumindest einen mit einem Fügematerial (50) darauf gefügten Leistungshalbleiter (200).

12. Leistungselektronische Baugruppe (1) nach Anspruch 11, wobei das Fügematerial (50) im gefügten Zustand eine maximale Höhe von 30 µm, insbesondere 20 µm oder 10 µm aufweist.

13. Leistungselektronische Baugruppe (1) nach Anspruch 11 oder 12, wobei der Leistungshalbleiter (200) mehrere Kontakte (210) aufweist, die an jeweils eine der Kontaktflächen (26) der Ausformungen (24) gefügt sind.

14. Verfahren zum Herstellen eines Substrathalbzeugs (100) nach einem der Ansprüche 1 bis 10, umfassend die Schritte:
Bereitstellen eines Substrats (10),
Aufbringen einer Leitebene (22) einer Leitstruktur (20),
Aufbringen von Ausformungen (24) aus der Leitstruktur (20),
sodass sich ein oder mehrere Kontaktflächen (26) ausbilden,
aufbringen eines Isolationsmaterials (30) auf die Leitebene (22) unter Aussparung der Kontaktflächen (26).
